# EUROPEAN PATENT APPLICATION

(11) **EP 4 412 417 A1**
(43) Date of publication of application: **07.08.2024**
(21) Application number: 24155185.2
(22) Date of filing: 01.02.2024
(51) Int. Cl.: H05K 7/20

(54) **VEHICLE COMPRISING A COOLING SYSTEM FOR AN ELECTRIC DEVICE**

(30) Priority: 02.02.2023 IT 202300001719
(71) Applicant: IVECO S.P.A., 10156 Torino (IT)
(72) Inventor: RUSSO, Gerardo, 10156 Torino (IT)
(74) Representative: Studio Torta S.p.A.

(57) **Abstract**

A vehicle equipped with a cooling system for an electric device (1), comprising a box (2) suitable for defining a space (3) suitable for housing the electric device (1) and a mechanical connection (4) for mechanically connecting the electric device (1) to said box (2), the cooling system comprising a liquid fluid (5) housed hermetically in the space (3) of the box (2) so as to submerge, at least partially, the electric device (1).

## Description

### CROSS-REFERENCE TO RELATED APPLICATIONS

This patent application claims priority from Italian patent application no. 102023000001719 filed on 02 February 2023, the entire disclosure of which is incorporated herein by reference.

### TECHNICAL SECTOR

This invention relates to a vehicle comprising a cooling system for an electric device.

This invention has its preferred, though not exclusive, application in cooling an electric device for vehicle uses such as a power electronics system. This application will be referred to below by way of example.

### PRIOR ART

There is an ever greater need to use at least partially electric vehicles in order to reduce vehicle consumption and, thus, environmental emissions.

At least partially electric vehicles use, as known, electric machines that exchange electricity, in use or being generated, with energy storage means, such as battery packs.

The electricity passing through the above-mentioned elements, and in relation to other elements using or producing it in the vehicle, is channelled by electric devices, such as, for example, inverters or PDUs (power distribution units).

These electric devices are placed inside protective housings, usually metal boxes, and fixed to them using appropriate fasteners. The inside of these protective boxes is normally empty, i.e. a space housing air.

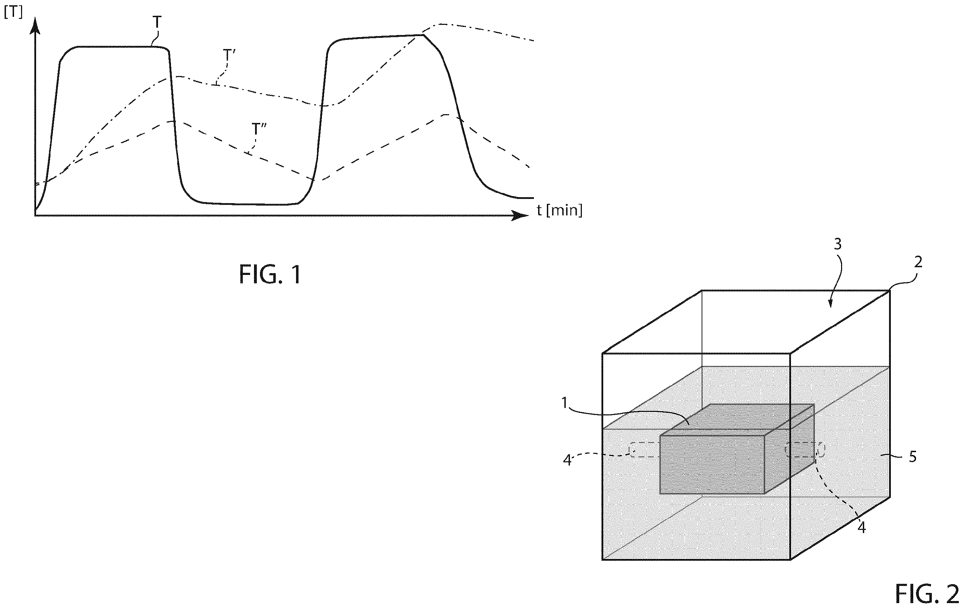

These elements managing the flow of electricity between the various vehicle elements tend to heat up as illustrated by way of example in Figure 1.

Figure 1 illustrates the temperature of the electric device as a function of time in relation to an operation curve T of the same. Usually, the above-mentioned electric devices may be exemplified by an ON-OFF curve or "square wave" representing the alternation between operating state and switched-off state.

As illustrated by the T' curve, the free air cooling of the electric devices in their housing is not enough since the temperature T' tends to continuously increase at each activation cycle of the electric device.

Thus, it is known to provide conditioning systems configured to actively cool the electric device, for example using forced ventilation or actual heat exchangers forming part of the refrigerant cycle conditioning systems.

Clearly, these active conditioning systems require power to be able to operate, reducing the overall efficiency of the vehicle.

In addition, active conditioning systems are bulky and, thus, reduce the vehicle's useful space, making it difficult to assemble and house other vehicle elements.

Again, the above-mentioned active conditioning systems often require maintenance, which entail vehicle stoppages that further increase the vehicle operating costs.

There is, thus, a need to cool electric devices for the vehicle in an efficient, compact, and cost-effective manner.

The purpose of this invention is to meet the needs outlined above in an optimal and inexpensive way.

### SUMMARY OF THE INVENTION

Said object is achieved by means of a vehicle as claimed in the appended claims.

### BRIEF DESCRIPTION OF THE DRAWINGS

For a better understanding of this invention, a preferred embodiment is described below by way of non-limiting example and with reference to the accompanying drawings, wherein:
- Figure 1 is a diagram illustrating the change in temperature as a function of time of an electric device during its operation;
- Figure 2 illustrates a first schematic embodiment of an electric device comprising a cooling system according to the invention;

- Figure 3 illustrates a second schematic embodiment of an electric device comprising a cooling system according to the invention; and
- Figure 4 illustrates a third schematic embodiment of an electric device comprising a cooling system according to the invention.

### DETAILED DESCRIPTION OF THE INVENTION

Figure 2 illustrates an assembly, for example a vehicle, comprising an electric device 1, such as an inverter, a DC/DC converter, or a PDU (power distribution unit), used, for example, in a vehicle system (not illustrated).

The electric device 1 is housed in a container 2 defining a space 3 for housing, advantageously insulated from the outside.

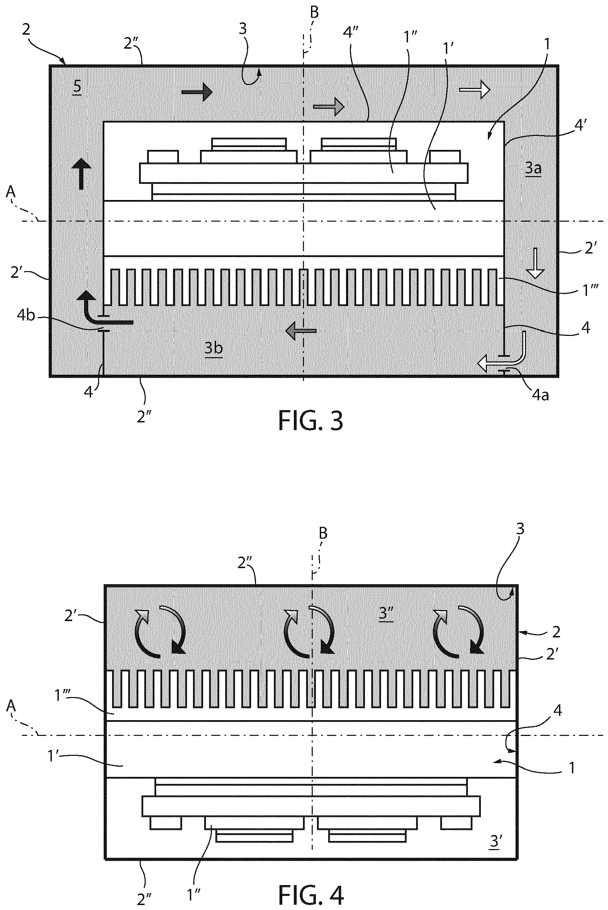

The device 1 is connected to the container 2 via at least one mechanical connection 4, such as, for example, connecting rods, elastic connections, welding, or connections in the form of housing electric cables/busbars as in the example illustrated in Figures 3 and 4, thus also providing an electrical connection outside the container 2.

According to the invention, a passive fluid conditioning system is provided comprising a liquid fluid 5 housed inside the space 3 hermetically sealed from the outside and so as to submerge the device 1 at least partially. In other words, the box 2 acts as a conditioning system when filled, at least partially, with liquid fluid 5.

In particular, this liquid fluid 5 is thermally conductive and electrically insulating. An example of this liquid fluid 5 consists of the oils or liquid salts 3M Novec 7500, MIVOLT DF7, or CARGILL 01973.

Alternatively, the liquid fluid 5 could consist of a phase change material such as paraffin waxes.

In the embodiment described, the liquid fluid entirely submerges the electric device 1 on each outer surface.

In the embodiments in Figures 3 and 4, the container 2 is schematically illustrated comprising a pair of first walls 2' facing each other and spaced apart along a first axis A, or longitudinal axis, and a pair of second walls 2" facing each other and spaced apart along a second axis B, or vertical axis, advantageously perpendicular to the first axis A. The first and second pair of walls 2', 2" are connected to each other in order to define the space 3. In any case, it is clearly possible that the box 3 is made of one or more elements connected together and of different shapes and types compared to what is illustrated.

In the embodiment in Figure 3, the mechanical connection is realised using a box-shaped element 4 fixed to the container 2 and dividing the space 3 into two portions, a first portion 3a outside the box-shaped element and a second portion 3b inside the box-shaped element 4.

The box-shaped element 4 also defines a first opening 4a and a second opening 4b configured to enable fluidic communication between the first and second portion 3a, 3b of the space 3.

More specifically, the box-shaped element 4 comprises a pair of first walls 4' facing each other along the direction of the first axis A and a second wall 4" extending transversely to the pair of first walls 4' and advantageously perpendicular to these.

The first and second openings 4a, 4b are preferably formed in the pair of first walls 4', one for each wall 4', while the electric device 1 is placed between the first pair of walls, for mechanical friction coupling friction, above the first and second openings 4a, 4b, i.e. along the direction of the second axis B.

Specifically, the pair of first walls 4' is fixed to one of the second pair of walls 2", for example the lower one along the direction of the second axis B. The pair of first walls 4' is also spaced apart along the direction of the first axis A in relation to the first walls 2' of the box 2 and the second wall 4" is spaced apart in relation to the wall 2" opposite the one for fastening the first walls 4' so as to create a channel between the openings 4a, 4b.

In further detail, the electric device 1 comprises a support portion 1' that carries an electronic processing portion 1" on one side and a dissipation portion 1‴ on the opposite side to the first side. At least the dissipation portion 1‴ is wet by the liquid fluid 5.

In the embodiment described, the support portion 1' is housed via friction and hermetically sealed inside the box-shaped element 4 keeping the electronic processing portion 1" insulated from the fluid 5, i.e. facing the second wall 2", and the dissipation portion 1‴ submerged in the fluid 5.

As known, the dissipation portion 1‴ comprises a profile, for example finned, configured to ease the exchange of heat with the outside to dissipate the heat generated by the electronic processing portion 1" that passes via the support portion 1'.

In the embodiment in Figure 4, the electronic device 1' is made similarly to the embodiment in Figure 3 comprising, i.e., a support portion 1', an electronic processing portion 1", and a dissipation portion 1‴.

In any case, in this embodiment, the support portion 1' is directly connected to the box 2 and the mechanical connection 4 is thus made via friction/shape coupling via the walls of a pair of walls of the latter opposite each other along the first axis A.

In this way, the device 1 divides the space 3 into a lower portion 3' along the axis B compared to an upper portion 3" along the axis B, fluidically separated between them thanks to the mechanical coupling 4 between box 2 and electric device 1.

In addition, the device 1 is placed so that it is opposite along the direction of the second axis B in relation to the embodiment in Figure 3, i.e. the dissipation portion 1‴ is placed above the electronic processing portion 1". In other words, the dissipation portion 1‴ is housed in the upper portion 3" of the space 3 compared to the direction of gravity, which houses the liquid fluid 5 that completely wets the dissipation portion 1‴.

The operation of the embodiment of the vehicle according to the invention described above is the following.

Essentially, according to the embodiment in Figure 2, as illustrated in the graph in Figure 1, the liquid fluid makes it possible to cool the electric device 1 more. Thus, in the inactivity phase of the operation curve T of the electric device 1, the liquid fluid lets heat disperse more rapidly (T" curve), thus maintaining the temperature of the electric device 1 below a pre-determined safety threshold temperature.

Referring to the particular operation of the embodiment in Figure 3, the operation is similar to that described above. In any case, thanks to the embodiment illustrated where the mechanical element 4 defines a passage channel with the box 2 for the fluid 5 via the two openings 4a, 4b, the cooling is improved. In fact, the heat transmitted by the dissipation means 1‴ heats the fluid 5 that tends to leave the opening 4b, circulate around the walls 4', 4", cooling down and returning from the opening 4a near the dissipation means 1‴. The recirculation of the liquid 5 described above, makes it possible to increase the dissipation of the heat of the electric device 1, making the cooling system even more effective.

Referring to the particular operation of the embodiment in Figure 4, the operation is similar to that described above in Figure 3. Therefore, in this case, the movement of the liquid fluid 5 is provided by the fact that the dissipation portion 1‴ faces upwards, in relation to the vertical, and thus the heated fluid tends to generate a convective motion that tends to move the liquid fluid increasing, similarly to the embodiment in Figure 3, its capacity to dissipate heat.

The advantages of a vehicle according to the invention are clear from the foregoing.

Thanks to the cooling system described, it is possible to effectively, cost-effectively, and compactly cool an electronic device, thus solving the issues related to the prior art systems.

In particular, it is possible to make the electric devices operate at greater frequencies, without having to forcibly increase the dimensions of the housing box or provide active conditioning systems.

In particular, the system is basically applicable, without additional bulk and with a reduced increase in weight, to any type of electric device without needing to change its fastening nor its arrangement.

The particular arrangements of the embodiments in Figures 3 and 4, which require a particular arrangement of the electric device, therefore make it possible to obtain additional, heat-dissipating capacity from the liquid fluid, thus further improving the capacity of the cooling system.

Lastly, it is clear that modifications and variations may be made to the vehicle according to this invention, without, however, departing from the scope of protection defined by the claims.

Clearly, as demonstrated, the mechanical coupling 4 and the electric device 1 can be made with any shape and type suitable for this purpose.

As mentioned, the liquid fluid can be of various chemical compositions as long as it is thermally conductive and electrically insulating.

Again, the electric device can be of any kind using electricity, such as a pure electric, electronic, or electromechanical device, such as an electric machine.

## Claims

1. A vehicle comprising an electric device (1) and a cooling system for said device, said cooling system comprising a box (2) suitable for defining a space (3) suitable for housing said electric device (1) and a mechanical connection (4) for mechanically connecting said electric device (1) to said box (2), said cooling system comprising a liquid fluid (5) housed hermetically in said space (3) of said box (2) so as to submerge, at least partially, said electric device (1)
wherein said liquid fluid (5) is thermally conductive and electrically insulating.

2. The vehicle according to claim 1, wherein said liquid fluid (5) completely submerges said electric device (1) .

3. The vehicle according to claim 2, wherein said liquid fluid is an oil or a liquid salt or a phase change material.

4. The vehicle according to one of the preceding claims, wherein said electric device (1) comprises a support portion (1') an electronic processing portion (1") carried by a part of said support portion (1') and a dissipation portion (1‴) carried on the opposite side of said support portion (1') with respect to said electronic processing portion (1‴), at least said dissipation portion (1‴) being immersed in said liquid fluid (5).

5. The vehicle according to claim 4, wherein said support portion (1‴) is carried directly by said box (2), said mechanical connection (4) being a contact connection between first walls (2') of said box (2) and said support portion (1"), said space (3) being divided by the coupling of said support portion (1") and said walls (2') into a first and a second portion (3', 3"), said second portion (3") being placed above the first (3') and housing said liquid fluid (5), said dissipation portion (1") being housed in said second portion (3").

6. The vehicle according to claim 4, wherein said mechanical connection (4) comprises a box-shaped element comprising a pair of first walls (4') and a second wall (4") extending transversely between said pair of first walls (4 '), said support portion (1') being carried between said first walls (4') and said electronic processing portion (1'') facing said second wall (1' '), said space 3 comprised between said boxed element and said box (2) being occupied by said liquid fluid (5).

7. The vehicle according to claim 6, in which a channel (3a, 3b) is defined between said first walls (4') and said second wall (4") and said box (2) which allows the circulation of said fluid liquid (5) around said boxed element.

8. The vehicle according to claim 7, wherein said first walls (4') each define an opening (4a, 4b) configured to allow the passage of said liquid fluid between an external portion (3a) of said box and an internal portion (3b) to said box.

9. The vehicle according to claim 8 in which said openings (4a, 4b) are placed at different heights.
